# EUROPEAN PATENT APPLICATION

(11) **EP 3 761 540 A1**
(43) Date of publication of application: **06.01.2021**
(21) Application number: 19305914.4
(22) Date of filing: 04.07.2019
(51) Int. Cl.: H04L 1/00, H03M 13/00

(54) **MITIGATING VITERBI DECODER PROCESSING LATENCY IN WIRELESS SYSTEMS**

(71) Applicant: NXP B.V., 5656 AG Eindhoven (NL)
(72) Inventor: SMAIL, Zahir, 31023 Toulouse Cedex 1 (FR); WAHEED, Khurram, Redhill, Surrey RH1 1QZ (GB)
(74) Representative: Miles, John Richard

(57) **Abstract**

A wireless device such as a transceiver includes a Viterbi engine and often is coupled to and receives a signal from a demodulator. The Viterbi engine includes a Viterbi decoder configured to decode the encoded bits of the received signal according to one of two processing rates. The Viterbi engine also includes a mode selector coupled to the Viterbi decoder, and a Viterbi mode controller providing a selection signal to the mode selector. The selection signal determines whether the Viterbi decoder operates according to either the first or second processing rate. A processing rate controller operates the Viterbi decoder at the first processing rate or the second processing rate, the second processing rate being faster than the first processing rate.

## Description

### BACKGROUND

A conventional radio receiver/transmitter (transceiver) and modulator/demodulator (modem) together implement the functions of a physical layer ("PHY") of a wireless data network to process a physical layer signal. The modem is coupled to a media access controller (MAC) that provides the next higher level functions of a data link layer in a layered communication model (e.g., the Open Systems Interconnection model (OSI) model). Because of typically high data rates, modems must quickly pass packet information to the MAC. Thus, high-speed wireless data networks require the receive processing latency at the modem (that is, the time from when the received RF energy finishes on a channel, to when the last byte of data in that packet is demodulated and passed to the MAC) to be as small as possible. For example, to comply with the IEEE 802.11a standard, the receive processing latency must be less than 12 microseconds (µs).

In many decoders, including Viterbi decoders, much of the demodulation time budget is consumed by a warmup phase of analog blocks (e.g., phase-locked loops (PLLs), crystal oscillators, receiver front-end, and calibrations). This approach leaves relatively little time for demodulation and the digital operation and control mechanisms to timely complete their operations before another communication cycle starts.

### BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.
FIG. 1 is a block diagram of a device providing variable speed processing with a Viterbi decoder in accordance with some embodiments.
FIG. 2 is a block diagram illustrating a Bluetooth Low Energy (BLE) coded physical layer packet in accordance with some embodiments.
FIG. 3 is a block diagram illustrating further details of the device of FIG. 1 in accordance with some embodiments.
FIG. 4 is a timing diagram illustrating a Viterbi input and output of the device of FIG. 1.
FIG. 5 is a timing diagram for BLE long range (LR) packet processing in accordance with some embodiments.
FIG. 6 is a timing diagram illustrating processing of parts of a BLE coded PHY packet according to two modes and two corresponding processing rates in accordance with some embodiments.
FIG. 7 is a timing diagram illustrating further processing of parts of a BLE coded PHY packet FEC block 1 in accordance with some embodiments.
FIG. 8 is a timing diagram illustrating a start of processing of the FEC block 2 of a BLE coded PHY packet in accordance with some embodiments.
FIG. 9 is a timing diagram illustrating an end of processing of the FEC block 2 of a BLE coded PHY packet in accordance with some embodiments.
FIG. 10 is a block diagram illustrating BLE transmission and BLE reception and decoding in a device in accordance with some embodiments.
FIG. 11 is a flow diagram illustrating a method for operating a device to decode bits of packets of a physical layer with a Viterbi decoder in accordance with some embodiments.

### DETAILED DESCRIPTION

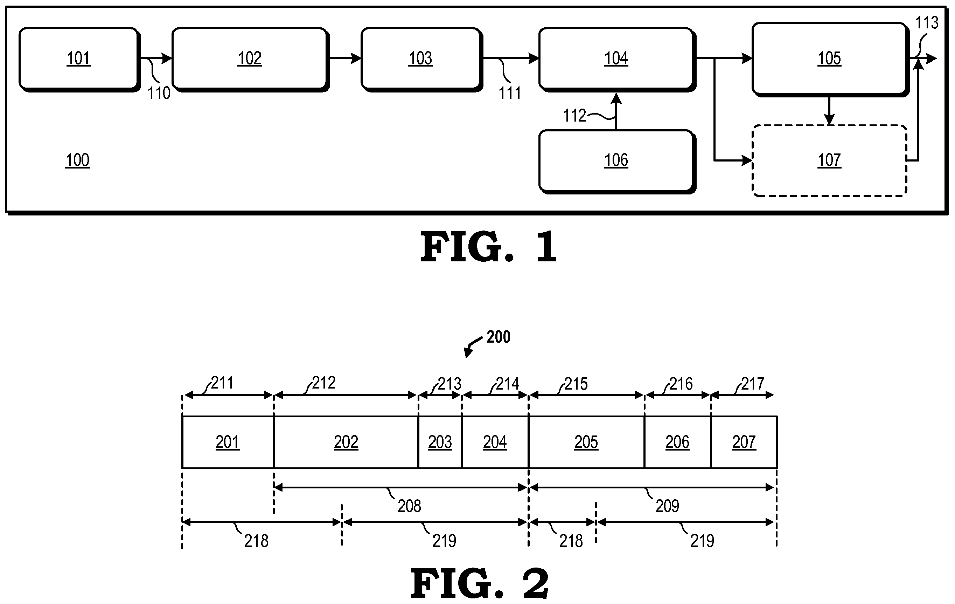

FIGs. 1-11 illustrate techniques for improving performance of a Viterbi decoder by configuring the Viterbi decoder to operate in at least two distinct processing modes within a device. A first mode supports low-power, low-speed operation while receiving a packet, or parts thereof, actively over the air. A second mode supports dynamically controlled use of a faster processing rate for data flushing that allows the Viterbi decoder to meet required protocol turn-around times (i.e., RX-TX switchover and vice versa).

According to at least some embodiments, the first mode is used until all packet bits of a given packet have been received and the second mode is used until all bits of the packet are processed before reception of another packet is initiated. The second mode performs data flushing where a payload length is programmed in a Viterbi controller state-machine. Alternatively, the payload length can be derived from a packet as processed by an external packet processing engine, such as the MAC layer. In the external packet processing engine, a Viterbi controller compares the payload length to a count of incoming data "valids" or pulses that indicate the correct sampling instant of the incoming data bits to the Viterbi decoder input stage. Once the Viterbi controller determines that a last payload bit has been received, the Viterbi controller state-machine is switched into the second mode and generates data pulses or bits at a faster rate, which enables the processing of all the bits already in the TB buffer to be flushed at a higher processing rate than in the first mode.

Operating the Viterbi controller state-machine at a higher speed allows a device to meet the timing turnaround required in certain communication standards. Currently, the timing turnaround poses a challenge in the design of wireless devices and systems. An example illustrates certain benefits of use of a second and faster processing mode. In the current version 5.0 Bluetooth Low Energy (BLE) protocol, a turnaround time value is fixed at 150 microseconds (µs). Approximately 80% of this time period is consumed during a warm-down phase of a radio in a first mode (e.g., RX mode, TX mode) and a warmup phase of the radio in a second mode (e.g., RX mode, TX mode) for certain analog circuit blocks (e.g., phase-locked loops (PLLs), an RF front end, crystal oscillators, and calibration engines). In these modes, no data bits are being processed. Generally devices employing Viterbi controllers employ components such as an analog-to-digital converter (ADC), a digital-to-analog converter (DAC), and other types of components and have data and non-data processing phases of operation. In non-data phases, devices perform turnaround tasks, spend time in a first radio mode flushing data and idling, perform warm-down tasks, and then perform warm-up tasks ahead of a second mode or other radio mode in which data are processed. In some circumstances, these devices also spend time priming certain structures and functional components in the second radio mode.

Only a small amount of the time remains for the digital design and control mechanisms of these devices, and during this time, there is always interest to idle device components to minimize power consumption. The limited time available for processing is a stringent constraint on receiver processing latency, especially for a coded physical layer ("PHY"). The turnaround time constraint becomes significantly more stringent when a Viterbi decoder algorithm and forward error correction (FEC) are used, like in BLE long range or IEEE 802.15.4-2015 or IEEE 802.11-based receivers. Further, some wireless packet structures, such as packets used in the BLE Long Range (LR) protocol, use two different schemes for encoding blocks of the packet header and the packet payload, respectively. A packet header may be a header of a protocol data unit. While this flexibility allows use of different coding strengths for the packet header and payload, it also creates a more stringent requirement on completing processing of a first of two FEC coded blocks in each packet because processing of a second FEC coded block can only be started after information is extracted from the first FEC coded block.

FIG. 1 is a block diagram of a device 100 providing two modes of operation and variable speed processing with a Viterbi decoder in accordance with some embodiments. Examples of the device 100 include a wireless device, a receiver, and a transceiver. The device 100 includes a receiver (RX) front end (FE) labeled as RXFE 101, a demodulator 102, a despreader 103, a Viterbi decoder (VD) 104, a forward error correction (FEC) processor 105, and a mode selector 106. The device 100 illustrates an overview of structures for processing in-coming packets according to the current version 5.x BLE protocol where the BLE protocol is an example of many protocols with which the techniques described herein can be employed. In the BLE protocol, the LE coded PHY uses a physical packet structure where each packet of bits is sequentially separated into a preamble and two forward error correction (FEC) blocks: FEC block 1 and FEC block 2. FEC provides resistance to random bit errors in a received payload but adds extra bits that must be included in each packet.

In operation, the device 100 processes an incoming PHY signal 110. The PHY signal 110 carries a sequence of packets, and each packet includes, in sequence, a preamble, an FEC block 1, and an FEC block 2. The device 100 first processes the preamble of each packet. As the preamble is generally short, the preamble is processed according to the first mode. Next, the FEC block 1 is demodulated by the demodulator 102 and then passed for de-spreading to the despreader 103. A despread, demodulated signal 111 is passed to the Viterbi decoder 104 for further processing. In some embodiments, and as further explained herein, the despread, demodulated signal 111 is provided either as individual bits or as pairs of soft bits (SBs) to the Viterbi decoder 104 where each pair of SBs corresponds to a single bit of incoming data received by the device. The demodulated FEC block 1 is processed by the Viterbi decoder 104 according to one of at least two modes: a single-bit processing mode corresponding to a first processing rate and a data-flush processing mode corresponding to a second processing rate faster than the first processing rate. In a first example of processing, when the FEC block 1 is relatively small in terms of the number of bits therein, the Viterbi decoder 104 stores all incoming bits from the incoming PHY signal 110 in a buffer (not illustrated) and later processes the stored bits according to the second, faster mode at a relatively fast processing rate based on a processing signal 112 provided to the Viterbi decoder 104 by the mode selector 106.

In an example of the data-flush processing mode, the FEC block 1 is processed according to the two different modes: a first mode corresponding to a first (slower) rate while processing a first portion of the FEC block 1 and a second mode corresponding to a second (faster) rate while processing a second portion of the FEC 1 block.

The switch from the first mode to the second mode is caused by the processing signal 112 provided to the Viterbi decoder 104 by the mode selector 106 at a time determined by the device 100. According to some embodiments, the first portion of the FEC block 1 is processed at a variable processing rate determined by input data valid pulses, where initially received bits are processed at a lower rate corresponding to a same rate at which bits are received and bits of a remainder of the received bits of the FEC block 1 are processed at a higher rate once all bits of the FEC block 1 are received by the despreader 103. Decoded bits from the Viterbi decoder 104 are provided to the FEC processor 105 and are further processed for errors, if any, according to a forward error correction scheme. Alternatively, or in addition to FEC processing, at block 107, bits are subjected to additional data processing in the device 100 before being provided as bits of an output signal 113. FIG. 2 is a block diagram illustrating a Bluetooth Low Energy (BLE) coded physical layer packet 200 and multi-mode processing in accordance with some embodiments . The packet 200 includes a preamble 201, an FEC block 1 208, and an FEC block 2 209. The FEC block 1 includes an access address (AA) 202, a coding indication (CI) 203, and a first termination ("term 1") sequence 204. The FEC block 2 includes a protocol data unit (PDU) 205 that is N bytes long, cyclic redundancy check (CRC) bits 206, and a second term sequence 207. For example, the PDU 205 is a Linked Layer (LL) data unit as BLE provides for a full communication protocol stack.

According to version 5.0 Bluetooth Low Energy (BLE) protocol, when enabled, the CI 203 indicates one of two different coding schemes, termed S=2 and S=8, where S refers to spreading. According to this coding scheme, bits are provided individually either as a single bit (0 and 1) for S=2 (no spreading pattern) or provided as four bits according to the pattern "0011" for zero from an FEC encoder and the pattern "1100" for one from the FEC encoder. The pattern converts each bit from a convolutional FEC encoder into P symbols, where the value of P depends on the coding scheme in use. For Bluetooth-LE, when S=2 then there is no change (i.e., P=1), and when S=8 each bit from the FEC encoder produces four output bits (i.e., P=4) from a pattern mapper. The choice of coding scheme, S=2 or S=8 with the LE Coded PHY has two consequences. With S=2, range is approximately doubled, and with S=8, range is approximately quadrupled relative to previous versions of the Bluetooth standard. Due to a requirement for redundant data to support an FEC algorithm at a receiver, such pattern mapping impacts the number of symbols which must be transmitted and this mapping reduces an overall data rate. Specifically, one bit passed through both an FEC encoder and a pattern mapper becomes 2 bits when S=2, or becomes eight bits when S=8. According to the current scheme for the packet 200, FEC block 1 208 is always coded with S=8 for maximum redundancy and includes the coding indicator (CI) which is used to enable or disable despreading and to code FEC block 2 209 (i.e., S=2 or S=8). The extracted CI is interpreted for the FEC block 2 209. Each FEC block 1 and FEC block 2 ends with termination bits labeled as term 1 and term 2, which is a pattern such as "000" of length 1 less than the Viterbi constraint length. During bit stream processing, the termination bits have an effect of resetting an FEC encoder of a device. In the BLE protocol, the FEC block 2 includes a header and a length of this header is fixed and known beforehand. When the PDU is transporting data, the PDU has a format that includes: a 16-bit header, a variable size payload, and optionally a Message Integrity Check (MIC) field.

Each of the parts 201-207 of the packet 200 include a certain number of bits indicated by a respective length 211-217. For a constant processing rate, a length corresponds to a respective time of processing respective parts 201-207. For example, for a particular processing rate, processing times of the parts 201-207 correspond to 80 µs for the preamble 201, 256 µs for the AA 202, 16 µs for the CI 203, 24 µs for the term 1 204, (N*8*S) µs for the PDU 205 of N bits long and S is either 2 or 8, (24*S) µs for the CRC 206, and (3*S) µs for the term 2 207. For S=2, the length for the PDU 205 corresponds to a time of processing of 32 - 4,112 µs. For S=8, the length for the PDU 205 corresponds to a time of processing of 128 - 16,448 µs. Overall, the packet 200 takes between 462 and 17,040 µs to be decoded and received. These example values are based on S=2, where 2 symbols represent 1 bit thereby supporting a bit rate of 500 kb/s, and S=8, where 8 symbols represent 1 bit therefore supporting a bit rate of 125 kb/s.

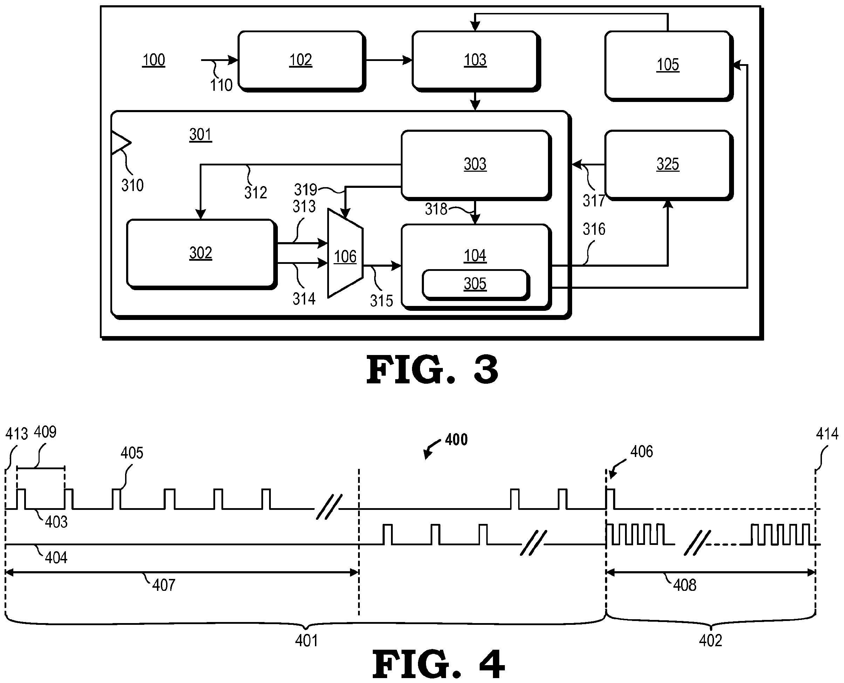

During processing (reception and demodulating) of the packet 200, a device, such as the device 100, operates in a first decoding mode by decoding with the Viterbi decoder 104 at a first rate during a first decoding time period 218 and operates in a second decoding mode by decoding with the Viterbi decoder 104 at a second rate during a second decoding time period 219. Both the first and second decoding modes are active during the first and second decoding time periods 218, 219 when processing each of the FEC block 1 208 and the FEC block 2 209. A starting point of the second decoding time period 218 relative to the first decoding time period 219 depends on a size of the packet 200 including a length of the variably-sized portions of the respective FEC blocks 208, 209. FIG. 3 is a block diagram illustrating further details of the device 100 of FIG. 1 in accordance with some embodiments. The device 100 provides variable speed processing by way of a Viterbi engine 301. In addition to the Viterbi engine 301, the device 100 includes the demodulator 102, the despreader 103, the FEC processor 105, and a packet processor 325. The Viterbi engine 301 includes a processing rate controller 302, a VD mode controller 303 coupled to the mode selector 106, and a Viterbi decoder 104. The VD mode controller 303 provides or otherwise facilitates an input signal 318 into the Viterbi decoder 104. The Viterbi decoder 104 includes a traceback buffer (TBB) 305 according to some embodiments. While not illustrated, the device 100 includes other structures and modules such as digital-to-analog controllers, digital-to-analog controllers, selectors, voltage regulators, variable gain amplifiers, phase locked loops, block decoders, pipelines, processing pipelines, buffers, et al., to process analog signals and digital bits as understood by those in the art.

Generally, in the device 100, VD latency is proportional to Viterbi trace back length (TBL) for each received packet which corresponds to a length of the TBB 305. A Viterbi TBL parameter determines an amount of look-back that the VD performs for a particular Viterbi algorithm. A higher TBL implies better decoding performance at the expense of timing, power consumption, increased latency, and a larger lookback buffer. The TBL latency is caused by the nature of the Viterbi algorithm as a maximum-likelihood algorithm which looks back at its previous decisions and, using certain constraints, predicts a possible decoding decision about a received signal. As an example for the TBB 305, using a TBL of 16 at a data rate of 125 kbps, a raw latency of decoding is 128 µs, which is not generally acceptable because the timing budget allocated is often less than 8-10 µs for the VD latency. As such, the turn-around time constraint becomes significantly more stringent when a conventional Viterbi decoder algorithm is used, like in BLE long range (LR), IEEE 802.15.4-2015, and IEEE 802.11-based receivers.

To address the turn-around time constraint, the Viterbi engine 301 is capable of operating in response to a single clock 310 at a substantially constant clock rate. The clock 310 is one example of a clock unit that provides a clock or clock signal to the Viterbi engine 301. A PHY signal 110 is provided to the demodulator 102. While not illustrated, the device 100 may include a RXFE 101 that provides the PHY signal 110 to the demodulator 102. A demodulated signal is passed to the despreader 103. For a BLE coded physical layer packet ("BLE packet") having S=2, bits are fed from the despreader 103 to the Viterbi decoder 104. For S=8, pairs of soft bits are fed from the despreader 103 to the Viterbi decoder 104.

Either the despreader 103 or an external despreader (not illustrated) identifies the coding information (CI) 213 from an FEC block 1 of each BLE 5.x coded PHY packet which is referred to as a "BLE packet." The CI is zero for all FEC block Is and the CI for each FEC block 2 is extracted from its FEC block 1. When enabled (CI=0 or S=8), the despreader 103 despreads demodulated data coming from the demodulator 102 by a factor of 4 for each corresponding BLE packet. The parts of the BLE packet are then provided by the despreader 103 via the VD mode controller 303 to the Viterbi decoder 104. The Viterbi decoder 104 starts by decoding received information bits at a first processing rate corresponding to a first processing mode indicated by a first processing path 313 based on a selection signal 319 (e.g., selection signal 319 is zero) provided to the mode selector 106. The first processing path 313 is illustrative of a signal provided to the mode selector 106 corresponding to the first processing mode. For example, the signal is a first data valid signal from the processing rate controller 302 that tells the Viterbi to process the signal received from the despreader 103. Generally, embodiments can employ a selection signal 319 based on receiving a pre-determined bit of a data packet encoded in a received signal or based on a known a-priori signal, bit, or condition.

Once decoded, the bits of each packet are sent to a link layer (LL) up a processing stack (not illustrated) of the device 100 for additional processing. A packet processor in the link layer (LL) extracts a payload length from a PDU header inside the PDU of the BLE packet. In operation, the VD mode controller 303 in the Viterbi engine 301 is a counter component and counts bits (S=2) or pairs of soft bits (SB) (S=8) sent to the Viterbi decoder 104. The Viterbi engine 301 compares the value of the count against the payload length provided by the packet processor 325 or where the payload length is programmed in a register of the Viterbi engine 301. When the count reaches the payload length, the VD mode controller 303 asserts a new selection signal 319 (e.g., selection signal 319 has a value of one) to switch to a second mode that involves a second and faster processing rate in the Viterbi decoder 104. This second mode and faster rate are provided by the processing rate controller 302 as represented by a second processing path 314 thereby causing the Viterbi decoder 104 to generate a stream of data bits. The second processing path 314 is illustrative of a second signal provided to the mode selector 106 corresponding to the second processing mode. For example, the second signal is a second stream of data valid pulses from the processing rate controller 302, the second data valid signal has a faster rate than the first data valid signal rate. The clock 310 is operated at a single clock rate by the device 100 during the first mode and the second mode, and the first processing rate and the second processing rate are based on the clock 310 of the Viterbi engine 301.

According to some embodiments, the second rate is a highest processing rate possible as provided by the Viterbi engine 301. The second mode is provided to the Viterbi decoder 104 as a rate control signal 315. This operation of the Viterbi engine 301 allows processing of soft bits (S=8) still in the traceback buffer (TBB) 305 at the relatively high second processing rate. This second mode of processing reduces the packet processing latency towards the end of each packet, which relaxes compliance to any protocol turn-around time requirements of the device 100, the Viterbi engine 301, and the Viterbi decoder 104. The Viterbi engine 301 implements a controller state-machine that is independent of the design of the Viterbi decoder 104 and deconvolution algorithm used therein.

FIG. 4 is a timing diagram 400 illustrating a Viterbi input and a Viterbi output of the Viterbi decoder 104 of the device 100 of FIG. 3 between a first time 413 and a second time 414. A first region 401 corresponds to the first mode wherein the Viterbi decoder 104 is operated at a first and nominal speed. A second region 402 corresponds to the second mode wherein the Viterbi decoder 104 is operated at a second speed faster than the first speed. The Viterbi input is represented by a first trace 403 over time with time proceeding from left to right. The Viterbi output is represented by a second trace 404. The first trace 403 includes input-valid pulses 405 in the signal for each synchronized pair of soft bits (S=8) provided by the despreader 103 which is also known as a de-spreading module. According to some embodiments, for each packet, the Viterbi input, as represented by the first trace 403, is processed into the Viterbi output at the first rate of the first mode. A first pulse is not visible as part of the Viterbi output until after a latency period 407 corresponding to 128 µs later as an illustrative processing rate. According to some embodiments, this latency period 407 depends on a size of a Viterbi's traceback length (TBL) associated with the Viterbi decoder 104 or the TBB 305.

A time interval 409 between two consecutive bits is equal to 1/Rb where Rb is a rate of bits being received and processed. For a BLE coded packet (S=8), the time interval corresponds to approximately 8 µs. This interval 409 corresponds to a maximum TBL of 128 µs for the BLE packet. At a time 406 that a last pulse pair or input-valid pulse 405 is received by the device 100 or the Viterbi decoder 104, the Viterbi decoder 104 is switched into the second mode and processing proceeds at the second, faster rate as indicated in the second region 402. By using input-valid pulses 405 at a fixed frequency, an operating frequency of other data path elements remains constant while increasing a frequency of operation of the Viterbi decoder 104 required for the internal VD processing cycles. The timing closure and routing are thereby simpler for a Viterbi engine having a Viterbi decoder 104 and other data path elements.

At the arrival of the last bit signal (also referred to as an end-of-packet (EOP)), the VD processing rate is changed to the second rate by generation of fast data bits to speed up VD processing of the bits or SBs that are still stored in the Viterbi decoder 104, and particularly those in the TBB 305. For example, using the BLE LR 125 kbps processing rate, second mode processing occurs at 4 MHz or faster and a TBL = 16. For reference, BLE LR 125 kbps corresponds to a BLE coded PHY (S=8). A tail latency τ is represented as a second time period 408 and a corresponding duration reduces to TBL divided by the fast processing rate, which corresponds to a time of (16 / 4 MHz) or 4 µs. An increased number of bits per unit time are output in the second time period 408 in corresponding to the second mode of operation of the VD engine.

In practice, the second rate is equal to the clock 310 divided by K_{TB} as a number of cycles of clock or valid signal that the Viterbi engine consumes for a traceback lookup. Both the clock 310 and the K_{TB} are chosen based on analyzing processing rate requirements of both the FEC block 1 and the FEC block 2 for a BLE packet such as packet 200, or based on another packet processing requirement using a protocol other than the BLE LR protocol. By using the second, faster rate, latency is reduced transparently to the Viterbi decoder 104 operated by the Viterbi engine 301. Using the faster rate improves VD latency for the device 100 when the device 100 is required to meet a protocol-defined timing deadline. No extra processing is required by the Viterbi decoder 104. As is evident in the receiving device 100, no extra PHY hardware storage (e.g., a first-in, first out (FIFO) buffer) is needed to process the Viterbi input represented by the first trace 403. An increased speed of processing is achieved by switching VD processing to the second, faster speed at a certain time such as illustrated at the time 406.

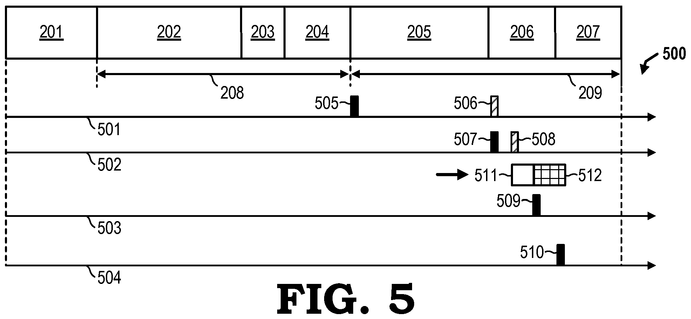

FIG. 5 is a timing diagram 500 for a case where traceback length (TBL) is 16 and the coding mode S is 2 for BLE LR packet processing. Along a top portion of the timing diagram 500, parts 301-307 of a packet are shown including an FEC block 1 208 and an FEC block 2 209. A Viterbi input is shown by a first trace 501. A corresponding Viterbi output is shown by a second trace 502. A timing for a length indicator 509 is illustrated by a third trace 503. A timing for switching into a second, faster rate of a second mode is illustrated by a fourth trace 504.

The first trace 501 includes a first bit of a header 505 labeled "H" and a last bit of a header length 506 in the Viterbi input where the length is a field. The header 505 and header length 506 are included in the PDU 205 of the packet. The first trace 501 is representative of a signal passing from the demodulator 102 to the Viterbi decoder 104. The second trace 502 illustrates the header 507 and the header length 508 exiting the Viterbi decoder 104 and passing to the packet processor 325 for LL-related processing (i.e., PDU-related processing). The third trace 503 indicates a time (e.g., at length indicator 509) at which the header length 506 is decoded and available to the Viterbi decoder 104 and Viterbi engine 301. A first timing budget of 4 µs 511 is allocated for the LL processing to extract the header length 506, dewhiten, and provide a value back to the PHY layer including the Viterbi engine 301. A second timing budget of 8 µs 512 is then available for the PHY layer to interpret the header length 506 and determine a time to switch into the second mode and the corresponding second, faster processing rate. In this second timing budget 512, the Viterbi engine 301 gives an indication to the link layer (LL) to prepare itself for the second mode and its faster processing rate.

The fourth trace 4 illustrates a time 510 when the second mode of the Viterbi engine 301 is started and a second, faster processing rate is engaged for the Viterbi decoder 104 based on obtaining the header length 508. For a BLE LR packet, there is an overall budget of 12 µs for the PHY layer to interpret the length and determine the instant of switching to the faster valid signal and giving an indication to the LL to prepare itself for an increased valid rate for the Viterbi decoder 104 and related components to flush out remaining bits of the packet. In summary, as illustrated in FIG. 5, the PHY layer needs the header length 506 from, and decoded by, the LL represented by the packet processor 325, and the PHY layer provides to the LL an indication to switch to the second, faster valid rate at the designated time 510 in the fourth trace 504.

The timing diagram 500 represents one scenario for payload length feedback in BLE coded PHY (S=2 Mode, or BLE-LR 500 kbps) packet processing. To implement a method of processing according to this timing diagram 500, the link layer (LL) provides the payload length parameter to a state machine of the Viterbi decoder 104. The VD mode controller 303 receives the payload length that is either programmed or extracted from a PDU header. The exchange between the packet processor 325 (processing bits of the LL) and VD mode controller 303 complies timing constraints, even for a smallest packet, at a highest rate supported by the device 100 which is S=2 or 500kHz for the BLE coded PHY layer. In the current (5.0) BLE protocol, the smallest packet 200 includes a packet header of 16 bits followed by CRC of 24 bits. As illustrated in the timing diagram 500, a timing budget for the LL is fixed to 4 µs for length indication and 8 µs for payload data path preparation for the extreme scenario. In the general case, a Viterbi decoder decodes incoming received bits and sends its output to a packet-processor such as the LL, which extracts a length from the VD decoded bits, and the LL sends the length back to the PHY layer where the VD is located. A VD engine then compares its local count of input-valids with the decoded length to control the sequence.

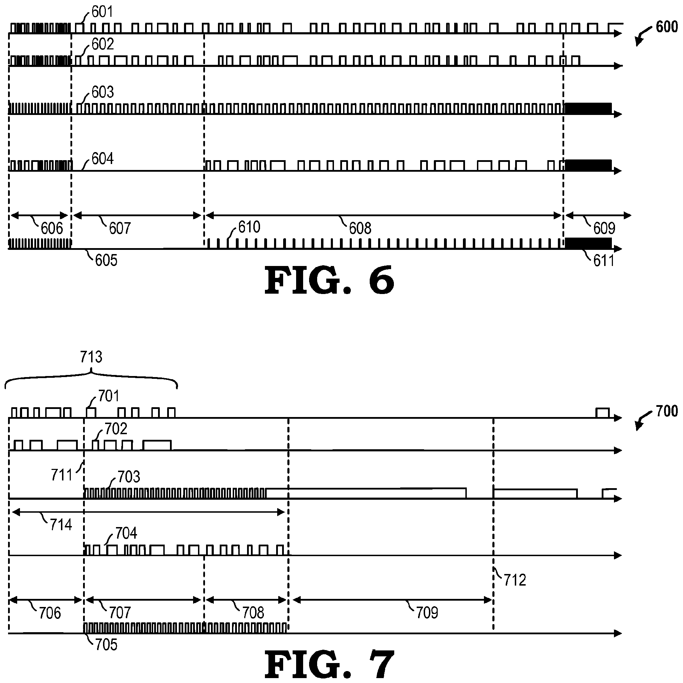

FIG. 6 is a timing diagram 600 illustrating processing of parts of a BLE coded PHY packet according to two modes and two corresponding processing rates different from one another. The timing diagram 600 includes a plurality of timing traces 601-605. A first trace 601 illustrates a first of two Viterbi inputs (i.e., a first of two soft bits), and a second trace 602 illustrates a second of the two Viterbi inputs (i.e., a second of the two soft bits). A third trace 603 illustrates an input-valid signal as a Viterbi input to the Viterbi decoder 104 that indicates the instant that both Viterbi inputs should be sampled to latch valid data. The third trace 603 corresponds to the input signal 318 provided to the Viterbi decoder 104. A fourth trace 604 illustrates a Viterbi output as decoded bits generated by the Viterbi decoder 104. A fifth trace 605 illustrates a Viterbi valid output pulse that informs the digital blocks after VD, e.g., link-layer on what is the best instant to sample the Viterbi decoded output. Further link-layer may also count "valid" pulses as a way of counting bits leaving the Viterbi decoder 104. The timing diagram 600 is divided into four regions or time periods corresponding to a last portion of FEC block 1 processing 606, and three phases 607-609 of FEC block 2 processing.

According to some embodiments, at least a portion of the FEC block 1 processing 606 is performed at a second, faster processing rate of a second mode as indicated by tightly spaced bits in the timing traces 601-605. In other embodiments, an entirety of the FEC block 1 processing is performed at the second, faster processing rate before a first phase 607 of the FEC block 2. In some embodiments, and as illustrated, decoding of the FEC block 2 is at a variable processing rate that can be entirely controlled by the rate of input data valid pulses. In the first phase 607, processing occurs at a first rate that is slower than the second processing rate. The first phase 607 shows a latency in the lack of incoming bit counts or data pulses 610 in the fifth trace 605 before a first bit of the PDU of the packet appears in a second phase 608 as in the fourth trace 604. The first phase 607 takes (TBL × BitRate) seconds to complete. In the second phase 608, decoding of the PDU bits is also performed by the Viterbi decoder 104 at a first processing rate or BitRate frequency. In a last and third phase 609 of decoding the FEC block 2 of the packet, upon a last bit entering the Viterbi decoder 104, the processing rate is switched to the second mode, to flush Viterbi memory as fast as possible where the Viterbi memory includes at least the TBB 305. The faster rate of the second mode is illustrated in tightly spaced bits 611 of the third phase 609.

FIG. 7 is a timing diagram 700 illustrating further processing of parts of a BLE coded PHY packet according to two modes and two corresponding processing rates. The timing diagram 700 includes a plurality of timing traces 701-705 similar to the timing traces 601-605 of the timing diagram 600. A first trace 701 illustrates a first of two Viterbi inputs, and a second trace 702 illustrates a second of the two Viterbi inputs. A third trace 703 illustrates an input-valid signal as a Viterbi input to the Viterbi decoder 104. The third trace 703 is provided to the Viterbi decoder 104 as the input signal 318 in the device 100. A fourth trace 704 illustrates a Viterbi output as decoded bits generated by the Viterbi decoder 104. A fifth trace 705 illustrates a Viterbi data valid output that indicates that the fourth trace 704 is valid at the rising edges of 705. In addition, a counting of "valid" pulses allows for counting bits leaving the Viterbi decoder 104. The timing diagram 700 is divided into regions 706-709 or time periods for sake of explanation.

The timing diagram 700 provides further details in a closer view of processing and decoding of the FEC block 1 208 of a packet. The timing diagram 700 illustrates a start of the FEC block 2 209. One FEC block 1 constraint is to retrieve the access address (AA) 202 and the CI 203 before arrival of a first bit of the FEC block 2 209. In this example, the AA and CI bits are indicated in a first section 713 of the Viterbi inputs in the first two traces 701, 702. The entire FEC block 1 208 is decoded at the second, fast processing rate as indicated by tightly spaced valid input signal values of the third trace 703 and by tightly spaced valid output signal values of the fifth trace 705 during a first fast processing time 714. Based on a same fast processing rate, an initial latency in a first phase 706 and in a flushing phase indicated by the third region 708 have a same duration. As an example, processing a VD traceback length of 16 at 16 MHz would consume 1 µs.

Without a faster processing rate, processing of the first FEC block 1 would process from a first time 711 to a second time 712 without pause. However, by having the Viterbi decoder 104 process the Viterbi inputs, represented by the first two traces 701, 702, at the second, faster rate, the device 100 and Viterbi engine 301 have a relatively idle time indicated by a fourth region 709 labeled "time before FEC BLK 2" in the timing diagram 700. The bits of the FEC block 1 are decoded in a timing window indicated by a second region 707 and a third region 708. With the faster processing rate, the Viterbi engine 301 and Viterbi decoder 104 complete decoding of the FEC block 1 by an end of the third region 708. During the time of the fourth region 709, one or more components of the Viterbi engine 301 can be powered down or remain idle until the second time 712 when processing of the FEC block 2 begins. In this way, the device 100 consumes a lower average power during operation. A timing margin before arrival of a first bit of the FEC block 2 depends on: (1) a coded mode corresponding to 125 kbps for S=8 and 500 kbps for S=2, and (2) a number of TERM bits that are decoded and latency consumed by the PHY to detect the AA 202.

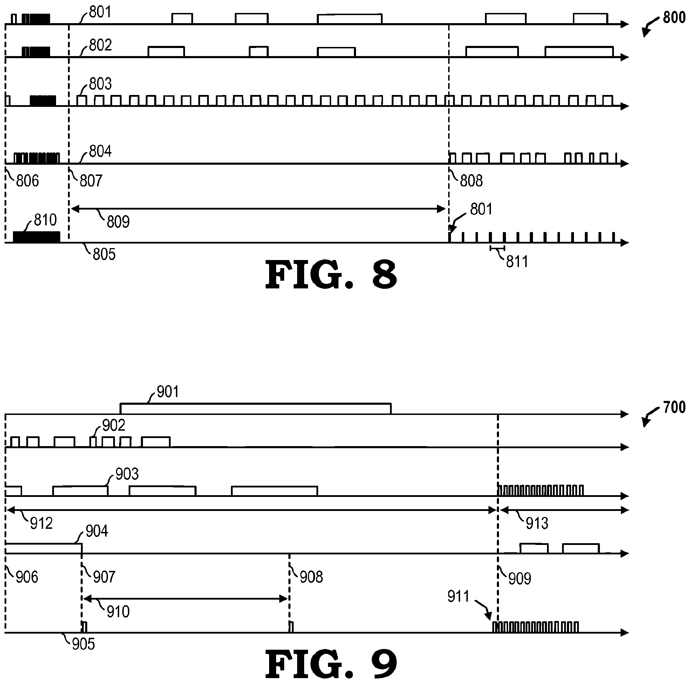

FIG. 8 is a timing diagram 800 illustrating a start of processing of the FEC block 2 209 of a BLE coded PHY packet in accordance with some embodiments. The timing diagram 800 includes a plurality of timing traces 801-805 similar to the timing traces 601-605, 701-705 of previous timing diagrams 600, 700. A first trace 801 illustrates a first of two Viterbi inputs, and a second trace 802 illustrates a second of the two Viterbi inputs. A third trace 803 illustrates an input-valid signal as a Viterbi input to the Viterbi decoder 104. The third trace 803 is provided to the Viterbi decoder 104 as the input signal 318 in the device 100. A fourth trace 804 illustrates a Viterbi output as decoded bits generated by the Viterbi decoder 104. A fifth trace 805 illustrates a Viterbi output of "valid" counts for counting bits of the Viterbi decoder 104. The timing diagram 800 is divided into regions or time periods defined by timing lines 806-808 for sake of explanation.

Last bits of the FEC block 1 208 are processed in a first region between a first timing line 806 and a second timing line 807 according to the second, fast processing rate as indicated by tightly spaced valid output decoded bits of the fourth trace 804 and tightly spaced valid signal region 810 of the fifth trace 805. Next, starting at the second timing line 807, the third trace 803 illustrates that input continues to be provided to the Viterbi decoder 104. A latency period 809 at the Viterbi decoder 104 occurs in the output of the Viterbi decoder 104 as indicated in the fourth and fifth traces 804, 805. A time between an end of the FEC block 1 and the instant that a first bit of the FEC block 2 is generated as Viterbi output in the fourth and fifth traces 804, 805 is given by TBL / BitRate, which is 128 µs for the 125 kbps processing mode for S=8 and 32 µs for the 500 kbps processing mode for S=2. At least during the latency period 809, processing of the initial FEC block 2 is received and decoded as received using the first processing rate corresponding to the first mode of processing as indicated by a wider distance 811 between successive output pulses after the third timing line 808 as compared with successive output pulses before the second timing line 807 and illustrated in the signal region 810 as a solid block of pulses. At least a first portion of the FEC block 2 is received and decoded using the first processing rate corresponding to the first mode of processing where the first processing rate is slower than the second processing rate.

FIG. 9 is a timing diagram 900 illustrating an end of processing of the FEC block 2 209 of a BLE coded PHY packet in accordance with some embodiments. The timing diagram 900 includes a plurality of timing traces 901-905 similar to the timing traces 601-605, 701-705, 801-805 of previous timing diagrams 600, 700, 800, respectively. A first trace 901 illustrates a first of two Viterbi inputs, and a second trace 902 illustrates a second of the two Viterbi inputs. A third trace 903 illustrates a signal as a Viterbi input to the Viterbi decoder 104. The third trace 903 is provided to the Viterbi decoder 104 as the input signal 318 in the device 100 wherein the input signal 318 can also be referred to as an input-valid signal. A fourth trace 904 illustrates a Viterbi output as decoded bits generated by the Viterbi decoder 104. A fifth trace 905 illustrates a Viterbi data-valid output that indicates that the signal represented by the fourth trace 904 is valid at the rising edges of 905. In addition, a counting of "valid" pulses allows for counting bits leaving the Viterbi decoder 104. The timing diagram 900 is divided into regions 906-909 or time periods for sake of explanation.

Last bits of the FEC block 2 209 are processed in a second region 913 between a fourth timing line 909 and an end of the timing diagram 900 according to the second, fast processing rate as indicated by tightly spaced pulses as Viterbi input of the third trace 903 and tightly spaced pulses of the fifth trace 905. The second, fast processing rate flushes out a VD memory of received FEC block 2 bits. At least some bits of the FEC block 2 209 are processed in a first region 912 prior to a time of the fourth timing line 909 according to the first mode which corresponds to the first processing rate that is slower than the second processing rate of the second mode. The first processing rate is indicated by the Viterbi output-valid signal in the fifth trace 905 prior to the fourth timing line which illustrates a time period 910 between successive pulses as 1 / bitrate. A much shorter period between successive pulses is illustrated starting at a first output-valid 911.

Upon a last pair of received SBs entering the Viterbi decoder 104 of the device 100 indicated near the fourth timing line 909 and the first output-valid 911, the VD mode controller 303 determines that all the expected over-the-air bits have arrived via the PHY signal 110. The VD mode controller 303 then switches the VD processing rate to flush out at least a portion of the VD memory (e.g., traceback buffer TBB 305) at the second, faster processing rate. A VD data flush duration depends on a Viterbi valid speed provided to the Viterbi decoder 104 and traceback propagation latency (K). The higher the Viterbi valid speed, the smaller the latency. Further, and according to some embodiments, traceback propagation latency (K) is a function of or based on a traceback length (TBL) of the Viterbi decoder 104 such as a size of the TBB 305. As a result of the illustrated embodiment, VD tail latency is independent of the received mode (S) or BitRate. The data flush speed increase is achieved by the VD mode controller 303 indicating to the processing rate controller 302 and Viterbi decoder 104 that it is time to flush using the VD mod controller output 312 and input signal 318 to the Viterbi decoder 104, respectively. The processing rate controller that generates input-valid pulses at a faster rate (e.g., determined by clock 310 and TBL KTB) causes the Viterbi decoder 104 to generate outputs at a faster rate. By way of example, this embodiment of a device 100, using TBL=16, a VD valid rate of 32 MHz, and a K_{TB} value of 2, yields a fast processing rate of (valid or clock rate) / K_{TB} = 16 MHz, where the VD tail or data flush latency is 1 µs.

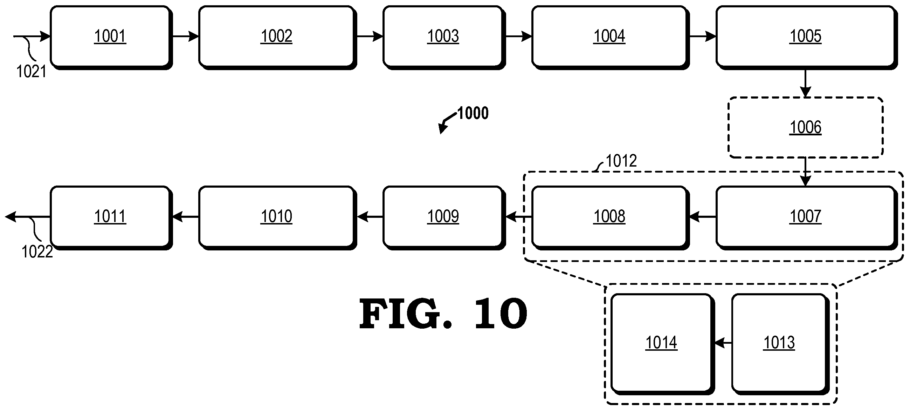

FIG. 10 is a block diagram 1000 illustrating bit stream processing of BLE transmission and BLE reception and decoding in a device in accordance with some embodiments. Prior to sending signals across a radio frequency (RF) interface 1006, transmission includes several steps: encryption 1001 of a transmission payload 1021, CRC generation 1002, whitening 1003, FEC encoding 1004, and pattern mapping 1005. Before transmission of a packet, whitening 1003 includes scrambling both the header and the payload of a packet with a data whitening word in order to randomize the data, eliminate highly redundant patterns, and minimize DC bias in the packet. The scrambling is performed prior to the FEC encoding 1004.

After receiving the signals across the RF interface 1006, reception includes several steps including decoding 1012. The decoding 1012 includes pattern demapping 1007 and FEC decoding 1008. Reception also includes dewhitening 1009, CRC checking 1010 and decryption 1011 to produce a received payload 1022. Processes and components within the step of decoding 1012 facilitate mitigation of latency associated with the Viterbi decoder processing. The decoding 1012 includes selecting an operating mode 1013 for operation of the Viterbi engine 301 and Viterbi decoder 104 and operating the same 1014 according to the selected mode. For example a second operating mode includes decoding at a second, faster decoding rate.

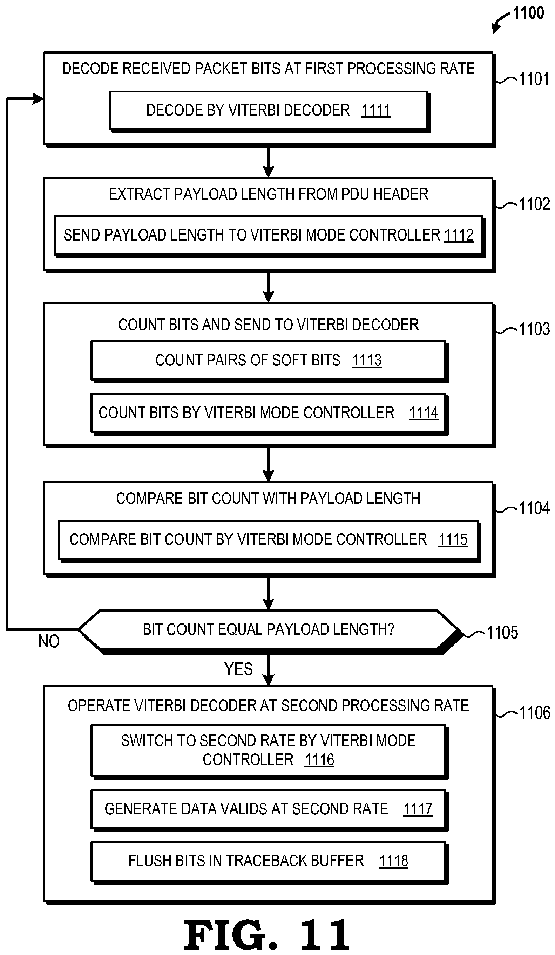

FIG. 11 is a flow diagram illustrating a method for operating a device to decode bits of packets of a physical layer with a Viterbi decoder in accordance with some embodiments. At block 1101, the method 1100 includes decoding received packet bits at a first processing rate. The first processing rate is associated with a first operating mode of a Viterbi engine such as Viterbi engine 301. At block 1111, the Viterbi engine decodes the received packet bits by operating a Viterbi decoder at the first processing rate.

At block 1102, a payload length is extracted from a PDU header. In some embodiments, block 1102 includes sending the payload length to a Viterbi mode controller at block 1112. In certain of these embodiments, and in greater detail, decoded bits are sent to a link layer (LL), the LL extracts the length from the header, and the LL sends the length back to the VD. The LL is a next higher layer in a communication model (e.g., the Open Systems Interconnection model) and a next layer for processing the payload of the physical layer packets. In some implementations, before obtaining the payload length from the PDU header from the LL, the VD mode controller uses a default value. For example, this value is initialized to a maximum of 255*8*S.

At block 1103, the device counts a number of bits or data pulses received by the device and provides this count to the Viterbi decoder. Depending on a mode or type of decoding scheme of the packets and protocol being used, at block 1113, the device counts pairs of soft bits. At block 1114, counting of bits is performed by a Viterbi mode controller.

Upon reaching a particular bit count, the device takes further action with regard to a second mode of operation. For example, the device compares the bit count with a payload length extracted from the PDU header at block 1104. At block 1115, the comparison is performed by a comparison unit such as the Viterbi mode controller. The comparison unit includes at least two inputs and at least one output. At block 1105, if the bit count has not reached the payload length, the device continues to decode received packet bits at the first processing rate. If the count has reached the payload length, at block 1106, the device or the Viterbi engine operates the Viterbi decoder at a second processing rate faster than the first processing rate. For example, at block 1116, the Viterbi mode controller switches operation of the Viterbi decoder to the second processing rate.

Operating the decoder at the second processing rate includes generating data pulses at the second processing rate at block 1117, and flushing bits in a traceback buffer associated with the Viterbi decoder at block 1118. Processing continues at either the first processing rate or the second processing rate as long as packets are received. In certain embodiments, the second processing rate is a maximal rate of operation of the Viterbi decoder depending on an amount of power or an increased valid rate available to the Viterbi engine for the Viterbi decoder relative to the rest of the device. A maximum rate of a Viterbi decoder such as the Viterbi decoder 104 depends on a number of clock cycles that the Viterbi decoder 104 needs to compute a valid output in data streaming conditions (i.e., the TBB is filled). At a minimum, the clock 310 of the Viterbi engine 301 needs to be greater than or equal to the KTB × data-processing rate. In at least some embodiments, the second processing rate is a variable rate where the rate is increased in steps or according to one or more of a proportional-integral-derivative (PID) control scheme until reaching an end of processing.

The descriptions above explained the techniques in relation to a Bluetooth-LE coded PHY example. The techniques can be applied to other standards, packet types, and transmissions where a first, lower rate streaming VD processing is followed by a second, faster rate data flush mode. Other standards where such processing can be used include the IEEE 802.11, IEEE 802.15 family of standards, cellular or mobile phone standards, and WMBUS that use convolutional encoding in a packet header, a packet payload, or both the packet header and the packet payload.

Embodiments may include the features recited in the following numbered clauses:
1. A wireless transceiver comprising: a Viterbi engine including: a Viterbi decoder configured to decode encoded bits of a signal; a mode selector coupled to the Viterbi decoder; a Viterbi mode controller providing a selection signal to the mode selector, the selection signal determining either a first mode or a second mode of operation for the Viterbi decoder; and a processing rate controller configured to set a first processing rate for the Viterbi decoder for the first mode and a second processing rate to the Viterbi decoder for the second mode, the second processing rate being faster than the first processing rate.
2. The wireless transceiver of clause 1, further comprising: a receiver front end configured to receive the signal; and a demodulator configured to receive a transmitted signal that includes the encoded bits, wherein the encoded bits are part of a packet.
3. The wireless transceiver of clause 2, further comprising: a despreader coupled to the demodulator and configured to provide a signal to the Viterbi engine based on the transmitted signal; and a forward error correction (FEC) processor coupled to the despreader, the FEC processor configured to receive bits from the Viterbi decoder.
4. The wireless transceiver of clause 3, wherein the Viterbi mode controller is configured to count bits or pairs of soft bits from the Viterbi decoder, and wherein the Viterbi mode controller provides the selection signal based on the counted bits or counted pairs of soft bits.
5. The wireless transceiver of clause 4, wherein the Viterbi mode controller provides the selection signal based on receiving a last payload bit received by the demodulator and decoded by the Viterbi decoder.
6. The wireless transceiver of clause 1, wherein the Viterbi engine further includes a clock, wherein the clock is operated at a single clock rate by the wireless transceiver during the first mode and the second mode, wherein the first processing rate and the second processing rate are based on an input-valid signal input of the Viterbi engine, and wherein the selection signal is based on receiving a pre-determined bit of a data packet encoded in the received signal or the selection signal is known a-priori.
7. A method for decoding a modulated signal, the method comprising: receiving a physical layer signal by a transceiver, the physical layer signal including encoded bits of a data packet including a last payload bit; decode bits in the physical layer signal until identifying a bit of the data packet in the physical layer signal; and based on the identified bit in the physical layer signal, operating a Viterbi decoder of the transceiver at a second processing rate faster than a first processing rate.
8. The method of clause 7, wherein the identified bit of the data packet is the last payload bit of the data packet.
9. The method of clause 7, further comprising: extracting a payload length from a header of a protocol data unit of the data packet, and wherein identifying the bit of the data packet in the physical layer signal includes comparing the payload length with a count of data pulses in the physical layer signal.
10. The method of clause 9, further comprising: getting the payload length from a link layer of the transceiver.
11. The method of clause 7, further comprising: counting data pulses by a Viterbi decoder mode controller based on the received physical layer signal; and extracting a payload length from a header of a protocol data unit of the data packet, wherein identifying the bit includes comparing counted data pulses against the extracted payload length.
12. The method of clause 11, wherein counting data pulses by the Viterbi decoder mode controller includes counting pairs of soft bits based on the received physical layer signal.
13. The method of clause 7, wherein operating the Viterbi decoder of the transceiver at the second processing rate includes processing encoded bits of a traceback buffer associated with the Viterbi decoder at the second processing rate.
14. The method of clause 7, wherein operating the Viterbi decoder of the transceiver at the second processing rate includes operating the Viterbi decoder at the second processing rate until an end of bits of the data packet.
15. A radio receiver for implementing a physical layer receiving function (PHY) of a wireless data network, the receiver comprising: a receiver front-end for receiving radio signals and including one or more analog-to-digital converters, wherein the receiver front-end provides samples of a received packet of data; a processing pipeline coupled to the receiver front-end to process the samples of the received packet of data, the samples entering the processing pipeline at a first sample rate; a counter counting a running count indicative of a number of samples that have entered the processing pipeline; a comparison unit coupled to the counter and configured to determine from the running count whether all the samples of a portion of the received packet have entered the processing pipeline, and provide an output indicative of whether or not all samples have entered the processing pipeline; and a clock unit coupled to the output of the comparison unit and configured to provide a clock signal to the pipeline, the clock unit causing the processing pipeline to process the samples entering the processing pipeline at a first rate compatible with the first sample rate until the comparison unit output indicates that all samples have entered the processing pipeline, thereafter the clock unit is configured to cause the processing pipeline to process the samples in the processing pipeline at a second rate higher than the first rate until a last sample of the portion of the packet has been output by the processing pipeline, such that a processing latency for processing the entire packet is reduced relative to the first rate.
16. The radio receiver of clause 15, wherein the processing pipeline includes a Viterbi decoder.
17. The radio receiver of clause 15, wherein the portion of the received packet is a first forward error correction coded block.
18. The radio receiver of clause 15, wherein the portion of the received packet is a second of two forward error correction coded blocks.
19. The radio receiver of clause 15, wherein the processing pipeline is configured to extract a payload length from a protocol data unit header derived from the radio signals, and send to a link layer of the radio receiver the extracted payload length.
20. The radio receiver of clause 16, wherein each of the counted samples is a pair of soft bits.

A wireless device such as a transceiver includes a Viterbi engine and often is coupled to and receives a signal from a demodulator. The Viterbi engine includes a Viterbi decoder configured to decode the encoded bits of the received signal according to one of two processing rates. The Viterbi engine also includes a mode selector coupled to the Viterbi decoder, and a Viterbi mode controller providing a selection signal to the mode selector. The selection signal determines whether the Viterbi decoder operates according to either the first or second processing rate. A processing rate controller operates the Viterbi decoder at the first processing rate or the second processing rate, the second processing rate being faster than the first processing rate.

Certain aspects of the techniques and components described above may be implemented by one or more processors of a processing (transmission-receiving) system with or without execution of software. In the case of software, the software includes one or more sets of executable instructions stored or otherwise tangibly embodied on a non-transitory computer readable storage medium. The software includes the instructions and certain data that, when executed by the one or more processors and components, manipulate the one or more processors to perform one or more aspects of the techniques described above. The non-transitory computer readable storage medium can include, for example, a magnetic or optical disk storage device, solid state storage devices such as Flash memory, a cache, random access memory (RAM) or other non-volatile memory device or devices, and the like. The executable instructions stored on the non-transitory computer readable storage medium may be in source code, assembly language code, object code, or other instruction format that is interpreted or otherwise executable by one or more processors.

A computer readable storage medium may include any storage medium, or combination of storage media, accessible by a computer system during use to provide instructions and/or data to the computer system. Such storage media can include, but is not limited to, optical media (e.g., compact disc (CD), digital versatile disc (DVD), Blu-Ray disc), magnetic media (e.g., floppy disc , magnetic tape, or magnetic hard drive), volatile memory (e.g., random access memory (RAM) or cache), non-volatile memory (e.g., read-only memory (ROM) or Flash memory), or microelectromechanical systems (MEMS)-based storage media. The computer readable storage medium may be embedded in the computing system (e.g., system RAM or ROM), fixedly attached to the computing system (e.g., a magnetic hard drive), removably attached to the computing system (e.g., an optical disc or Universal Serial Bus (USB)-based Flash memory), or coupled to the computer system via a wired or wireless network (e.g., network accessible storage (NAS)).

Note that not all of the activities or elements described above in the general description are required, that a portion of a specific activity or device may not be required, and that one or more further activities may be performed, or elements included, in addition to those described. Still further, the order in which activities are listed are not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. A wireless transceiver comprising:
a Viterbi engine including:
a Viterbi decoder configured to decode encoded bits of a signal;
a mode selector coupled to the Viterbi decoder;
a Viterbi mode controller providing a selection signal to the mode selector, the selection signal determining either a first mode or a second mode of operation for the Viterbi decoder; and
a processing rate controller configured to set a first processing rate for the Viterbi decoder for the first mode and a second processing rate to the Viterbi decoder for the second mode, the second processing rate being faster than the first processing rate.

2. The wireless transceiver of claim 1, further comprising:
a receiver front end configured to receive the signal; and
a demodulator configured to receive a transmitted signal that includes the encoded bits, wherein the encoded bits are part of a packet.

3. The wireless transceiver of claim 1 or 2, further comprising:
a despreader coupled to the demodulator and configured to provide a signal to the Viterbi engine based on the transmitted signal; and
a forward error correction (FEC) processor coupled to the despreader, the FEC processor configured to receive bits from the Viterbi decoder.

4. The wireless transceiver of any preceding claim, wherein the Viterbi mode controller is configured to count bits or pairs of soft bits from the Viterbi decoder, and wherein the Viterbi mode controller provides the selection signal based on the counted bits or counted pairs of soft bits.

5. The wireless transceiver of any preceding claim, wherein the Viterbi mode controller provides the selection signal based on receiving a last payload bit received by the demodulator and decoded by the Viterbi decoder.

6. The wireless transceiver of any preceding claim, wherein the Viterbi engine further includes a clock, wherein the clock is operated at a single clock rate by the wireless transceiver during the first mode and the second mode, wherein the first processing rate and the second processing rate are based on an input-valid signal input of the Viterbi engine, and wherein the selection signal is based on receiving a pre-determined bit of a data packet encoded in the received signal or the selection signal is known a-priori.

7. A method for decoding a modulated signal, the method comprising:
receiving a physical layer signal by a transceiver, the physical layer signal including encoded bits of a data packet including a last payload bit;
decode bits in the physical layer signal until identifying a bit of the data packet in the physical layer signal; and
based on the identified bit in the physical layer signal, operating a Viterbi decoder of the transceiver at a second processing rate faster than a first processing rate.

8. The method of claim 7, wherein the identified bit of the data packet is the last payload bit of the data packet.

9. The method of claim 7 or 8, further comprising:
extracting a payload length from a header of a protocol data unit of the data packet, and wherein identifying the bit of the data packet in the physical layer signal includes comparing the payload length with a count of data pulses in the physical layer signal.

10. The method of claim 9, further comprising:
getting the payload length from a link layer of the transceiver.

11. The method of any of claims 7 to 10, further comprising:
counting data pulses by a Viterbi decoder mode controller based on the received physical layer signal; and
extracting a payload length from a header of a protocol data unit of the data packet, wherein identifying the bit includes comparing counted data pulses against the extracted payload length.

12. The method of claim 11, wherein counting data pulses by the Viterbi decoder mode controller includes counting pairs of soft bits based on the received physical layer signal.

13. The method of any of claims 7 to 12, wherein operating the Viterbi decoder of the transceiver at the second processing rate includes processing encoded bits of a traceback buffer associated with the Viterbi decoder at the second processing rate.

14. The method of any of claims 7 to 13, wherein operating the Viterbi decoder of the transceiver at the second processing rate includes operating the Viterbi decoder at the second processing rate until an end of bits of the data packet.
